# EUROPEAN PATENT SPECIFICATION

(11) **EP 3 950 211 B1**
(45) Date of publication and mention of the grant of the patent: **15.05.2024**
(21) Application number: 21178257.8
(22) Date of filing: 08.06.2021
(51) Int. Cl.: B23K 26/352, B23K 26/354, B23K 26/0622, B23K 101/34, B23K 103/10, B23K 103/12, B23K 103/14, B23K 103/08

(54) **METHOD OF MANUFACTURING A METAL MEMBER**
VERFAHREN ZUR HERSTELLUNG EINES METALLELEMENTS
PROCÉDÉ DE FABRICATION D'UN ÉLÉMENT MÉTALLIQUE

(30) Priority: 03.08.2020 JP 2020131502; 11.12.2020 JP 2020205718
(43) Date of publication of application: 09.02.2022
(73) Proprietor: TOYOTA JIDOSHA KABUSHIKI KAISHA, Toyota-shi, Aichi-ken 471-8571 (JP)
(72) Inventor: UCHIMURA, Masahiro, Toyota-shi, 471-8571 (JP); NAKATA, Hiromichi, Toyota-shi, 471-8571 (JP); FURUKAWA, Masashi, Toyota-shi, 471-8571 (JP)
(74) Representative: J A Kemp LLP

(56) References cited:
- WO-A1-2018/074035
- JP-A- 2016 020 001
- JP-B2- 6 648 671
- US-A1- 2019 391 298

## Description

### BACKGROUND OF THE INVENTION

### 1. Field of the Invention

The present invention relates to a method of manufacturing a metal member

### 2. Description of Related Art

For improving the adhesiveness between a metal member and another member, it has been studied to provide a fine unevenness on the surface of the metal member to roughen the surface.

For example, Japanese Unexamined Patent Application Publication No. 2016-20001 (JP 2016-20001 A, describing all the features and steps of the preamble of claim 1) discloses that a surface of a thin metal film that is made of a material containing at least one of Ni, Au, Pd, and Ag, as a main component, is irradiated with an energy beam having a low energy density to melt and solidify the surface of the thin metal film, whereby the surface of the thin metal film is roughened.
WO 2018/074035 discloses also a method in accordance with the pre-characterising section of claim 1.

### SUMMARY OF THE INVENTION

However, in the method of JP 2016-20001 A, as described in the document, a surface of a thin metal film that is made of a material having a low melting point, such as aluminum (Al) or copper (Cu), as a main component, cannot be roughened.

The present invention provides a method of manufacturing a metal member that is capable of improving the adhesiveness to another member by having a fine uneven shape at least on a surface of a base material in which a material having a low melting point is used at least on the surface and a manufacturing method for a metal member.

A first aspect of the present invention relates to a method of manufacturing a metal member according to claim 1, that includes a base material of which at least a surface is made of a material containing any one of Cu, Al, Sn, Ti, and Fe as a main component, and an uneven portion having an uneven shape, which is formed on the surface of the base material. The first aspect includes forming the uneven portion. Forming the uneven portion includes irradiating a first region of the surface of the base material with a pulse-oscillating laser beam to melt the surface of the base material in the first region; generating metal particles from a vapor or plasma of a metal released to a predetermined atmosphere by melting the surface of the base material in the first region, and depositing the metal particles in the first region; irradiating a second region of the surface of the base material with the laser beam, the second region being adjacent to the first region, to melt the surface of the base material in the second region; and generating metal particles from a vapor or plasma of a metal released to the predetermined atmosphere by melting the surface of the base material in the second region, and depositing the metal particles in each of the second region and the first region adjacent to the second region. In the manufacturing method for a metal member, since a fine uneven shape can be provided even on a surface of a base material in which a material having a low melting point, such as Cu or Al, is used at least on the surface, the adhesiveness between the metal member and another member can be improved.

In the first aspect, the base material may be made of a material containing Al, as a main component, and irradiation conditions of the laser beam may be; a peak output of 3 kW or more, a pulse width of 1 ns to 1,000 ns, a laser spot diameter 200 µm or less, the laser spot diameter being a diameter of each of the first region and the second region, and a spot interval of equal to or smaller than the laser spot diameter, the spot interval being an interval between the first region and the second region, or the base material may be made of a material containing Cu, as a main component, and irradiation conditions of the laser beam may be; a peak output of 6 kW or more, a pulse width of 1 ns to 1,000 ns, a laser spot diameter 200 µm or less, the laser spot diameter being a diameter of each of the first region and the second region, and a spot interval of equal to or smaller than the laser spot diameter, the spot interval being an interval between the first region and the second region, or the base material may be made of a material containing Sn, as a main component, and irradiation conditions of the laser beam may be; a peak output of 1 kW or more, a pulse width of 1 to 1,000 ns, a laser spot diameter 250 µm or less, the laser spot diameter being a diameter of each of the first region and the second region, and a spot interval of equal to or smaller than the laser spot diameter, the spot interval being an interval between the first region and the second region, or the base material may be made of a material containing Ti, as a main component, and irradiation conditions of the laser beam may be; a peak output of 1 kW or more, a pulse width of 1 ns to 1,000 ns, a laser spot diameter 250 µm or less, the laser spot diameter being a diameter of each of the first region and the second region, and a spot interval of equal to or smaller than the laser spot diameter, the spot interval being an interval between the first region and the second region, or the base material may be made of a material containing Fe, as a main component, and irradiation conditions of the laser beam may be; a peak output of 1 kW or more, a pulse width of 1 ns to 1,000 ns, a laser spot diameter 250 µm or less, the laser spot diameter being a diameter of each of the first region and the second region, and a spot interval of equal to or smaller than the laser spot diameter, the spot interval being an interval between the first region and the second region.

In the first aspect, the base material may a thin metal film, on the surface, that is made of a material containing at least any one of Cu, Al, Sn, Ti, and Fe, as a main component, and the uneven portion may be formed on a surface of the thin metal film. In this manufacturing method for a metal member, since a fine uneven shape can be provided even on a surface of a thin metal film containing a material having a low melting point, such as Cu or Al, as a main component, the adhesiveness between the metal member and another member can be improved.

The first aspect may further include partially densifying the uneven shape of the uneven portion, after forming the uneven portion. Partially densifying the uneven shape of the uneven portion may include irradiating a predetermined region of the uneven portion formed on the surface of the base material with a laser beam weaker than the laser beam that is used in forming the uneven portion, to melt a deposit that forms the uneven shape of the uneven portion in the predetermined region. In this manufacturing method for a metal member, the uneven shape of the uneven portion formed on the surface of the metal member can be partially densified as compared with another part, and insulation resistance performance, corrosion resistance performance, and wear resistance performance can be improved in the densified part.

Further aspects of the present invention are defined in claims 2 and 3 respectively.

According to the present invention, a metal member that is capable of improving the adhesiveness to another member by having a fine uneven shape at least on a surface of a base material in which a material having a low melting point is used at least on the surface and a method of manufacturing a metal member can be provided.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG 1 is a schematic cross-sectional view of a metal member;
FIG2 is a flowchart illustrating a method of manufacturing the metal member illustrated in FIG 1;
FIG.3 is a schematic cross-sectional view for describing a manufacturing method for the metal member illustrated in FIG 1;
FIG.4 is a schematic cross-sectional view for describing a manufacturing method for the metal member illustrated in FIG 1;
FIG.5 is a schematic cross-sectional view for describing a manufacturing method for the metal member illustrated in FIG 1;
FIG6 is a schematic cross-sectional view for describing a manufacturing method for the metal member illustrated in FIG 1;
FIG7 is a schematic cross-sectional view for describing a manufacturing method for the metal member illustrated in FIG 1;
FIG 8 is a schematic cross-sectional view for describing a manufacturing method for the metal member illustrated in FIG 1;
FIG9 is a schematic plan view for describing a laser irradiation method at the time of manufacturing the metal member illustrated in FIG 1;
FIG 10 is an enlarged SEM image of a surface of a thin metal film containing Cu as a main component, where the thin metal film is provided in the metal member shown on Figure 1;
FIG 11 is a further enlarged SEM image of the surface of the thin metal film shown in FIG 10;
FIG 12 is an enlarged SEM image of a cross section of the thin metal film shown in FIG 10;
FIG 13 is an enlarged SEM image of a surface of a thin metal film containing Al as a main component, where the thin metal film is provided in the metal member shown on Figure 1;
FIG 14 is a further enlarged SEM image of the surface of the thin metal film shown in FIG 13;
FIG 15 is an enlarged SEM image of a cross section of the thin metal film shown in FIG 13;
FIG 16 is an enlarged SEM image of a surface of a thin metal film containing Cu as a main component, where the thin metal film is provided in the metal member according to a comparative example;
FIG 17 is a further enlarged SEM image of the surface of the thin metal film shown in FIG 16;
FIG 18 is an enlarged SEM image of a cross section of the thin metal film shown in FIG 16;
FIG 19 is an enlarged SEM image of a surface of a thin metal film containing Sn as a main component, where the thin metal film is provided in the metal member according to the first embodiment;
FIG 20 is a further enlarged SEM image of the surface of the thin metal film shown in FIG 19;
FIG 21 is an enlarged SEM image of a cross section of the thin metal film shown in FIG 19;
FIG 22 is an enlarged SEM image of a surface of a thin metal film containing Ti as a main component, where the thin metal film is provided in the metal member shown on Figure 1;
FIG 23 is a further enlarged SEM image of the surface of the thin metal film shown in FIG 22;
FIG 24 is an enlarged SEM image of a cross section of the thin metal film shown in FIG 22;
FIG 25 is an enlarged SEM image of a surface of a thin metal film containing Fe as a main component, where the thin metal film is provided in the metal member shown on Figure 1;
FIG 26 is a further enlarged SEM image of the surface of the thin metal film shown in FIG 25;
FIG 27 is an enlarged SEM image of a cross section of the thin metal film shown in FIG 25;
FIG28 is a flowchart illustrating a manufacturing method for a metal member according to a second embodiment;
FIG29 is a schematic cross-sectional view for describing the manufacturing method for the metal member, where the manufacturing method is illustrated in FIG 28;
FIG30 is a schematic cross-sectional view for describing the manufacturing method for the metal member, where the manufacturing method is illustrated in FIG 28;
FIG31 is a schematic cross-sectional view for describing the manufacturing method for the metal member, where the manufacturing method is illustrated in FIG 28;
FIG32 is a schematic cross-sectional view for describing the manufacturing method for the metal member, where the manufacturing method is illustrated in FIG 28;
FIG 33 is an enlarged SEM image of a part in which an uneven shape is densified by a weak laser, in a surface of a thin metal film containing Cu as a main component, where the thin metal film is provided in the metal member according to the second embodiment;
FIG 34 is a further enlarged SEM image of the surface of the thin metal film shown in FIG 33; and
FIG 35 is an enlarged SEM image of a cross section of the thin metal film shown in FIG 33.

### DETAILED DESCRIPTION OF EMBODIMENTS

Hereinafter, the present invention will be described through embodiments of the invention, but the invention according to the claims is not limited to the following embodiments. In addition, not all of the configurations described in the embodiments are indispensable as means for solving the problem. For clarifying the description, the following description and drawings may be omitted and simplified as appropriate. In the drawings, the same elements are designated by the same reference numerals, and the description thereof is not be duplicated as needed.

### First Embodiment

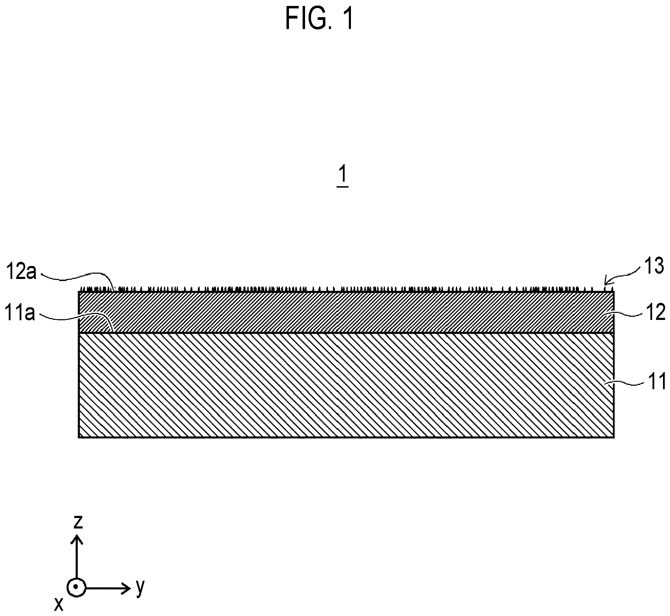

FIG 1 is a schematic cross-sectional view of a metal member 1. The metal member 1 is used, for example, as a lead frame on which a semiconductor chip is mounted, and the semiconductor chip is sealed by the metal member 1 and a sealing resin (another member). As a result, it is demanded the metal member 1 has improved adhesiveness to the sealing resin.

As illustrated in FIG 1, the metal member 1 includes a base material 11, a thin metal film 12, and an uneven portion 13. The base material 11 is a flat plate-shaped member and is made of a conductive metal material, such as Cu or Al. The thin metal film 12 is formed on a surface 11a of the base material 11. More specifically, the thin metal film 12 is formed on the main plane (the surface) of the base material 11. Here, the thin metal film 12 is made of a metal material containing any one of Cu, Al, Sn, Ti, and Fe as a main component, which has a melting point lower than that of Ni, Au, Pd, Ag, or the like. The thin metal film 12 can also be provided as a part of the base material 11.

Further, the uneven portion 13 having a fine uneven shape is formed on the surface 12a of the thin metal film 12. A part of the surface 12a of the thin metal film 12 is irradiated with a pulse laser (a pulse-oscillating laser beam), melted, vaporized, and then becomes particles, which are then deposited on the surface 12a of the thin metal film 12, and the uneven portion 13 is formed (the details thereof will be described later). As a result, the uneven portion 13 is made of a metal material containing the same metal (any one of Cu, Al, Sn, Ti, and Fe), as a main component, as that of the thin metal film 12.

As a result, in the metal member 1, the uneven portion 13 having a fine uneven shape is provided on the surface 12a of the thin metal film 12. Therefore, the adhesiveness between the thin metal film 12 and another member (a sealing resin or the like) can be improved.

Further, for example, in a case where the thin metal film 12 and another member are adhered to each other by using an adhesive agent, the anchoring effect can be enhanced by the fine uneven shape. Alternatively, as another application, in a case where the thin metal film 12 and another member are caused to move slidingly using a lubricant, it is possible to restrain the lubricant from being diffused.

### Manufacturing Method for Metal Member 1

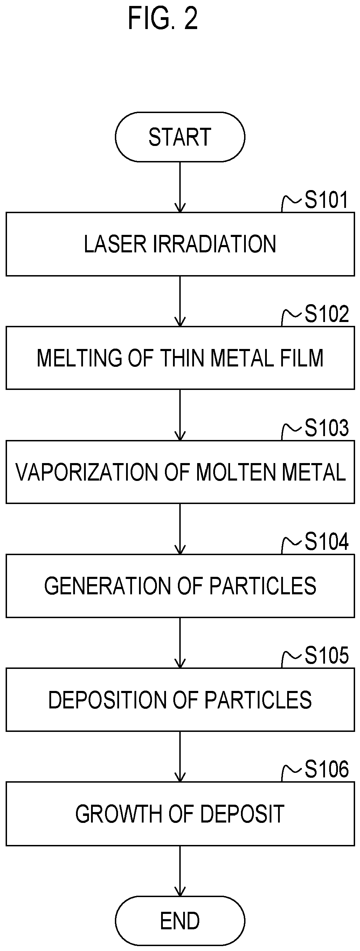

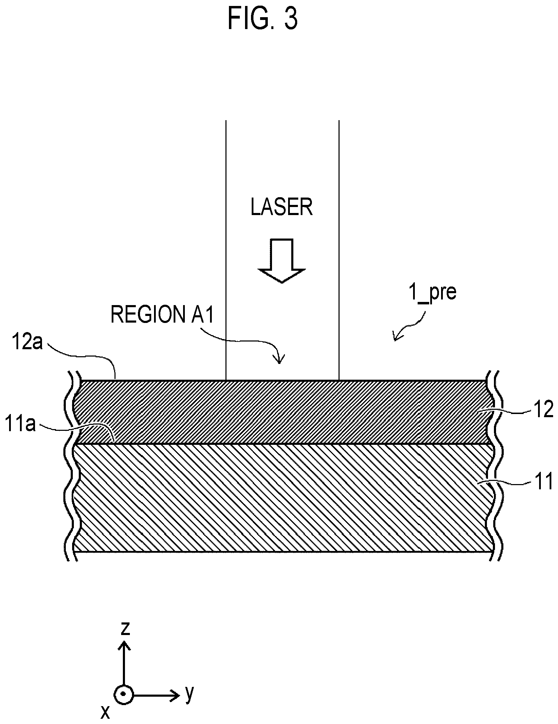

Subsequently, a manufacturing method for the metal member 1 will be described. FIG2 is a flowchart illustrating a manufacturing method for the metal member 1. In addition, FIG.3 to FIG 8 are schematic cross-sectional views for describing the manufacturing method for the metal member 1. FIG 3 to FIG 8 correspond to treatments of step S101 to step S106 of FIG 2, respectively.

First, the metal member 1 (hereinafter, referred to as the metal member 1_pre) before the uneven portion 13 is formed is prepared. As described above, the thin metal film 12 provided in the metal member 1_pre is made of a metal material containing any one of Cu, Al, Sn, Ti, and Fe, as a main component, which has a melting point lower than that of Ni, Au, Pd, Ag, or the like. Here, a case where the thin metal film 12 is made of a metal material containing Cu as a main component will be described as an example.

Then, a predetermined region A1 of the surface 12a of the thin metal film 12 provided in the metal member 1_pre is irradiated with a pulse laser (see step S101 of FIG.2 and FIG 3). The predetermined region A1 is, for example, a region that can be irradiated with a pulse laser at one time.

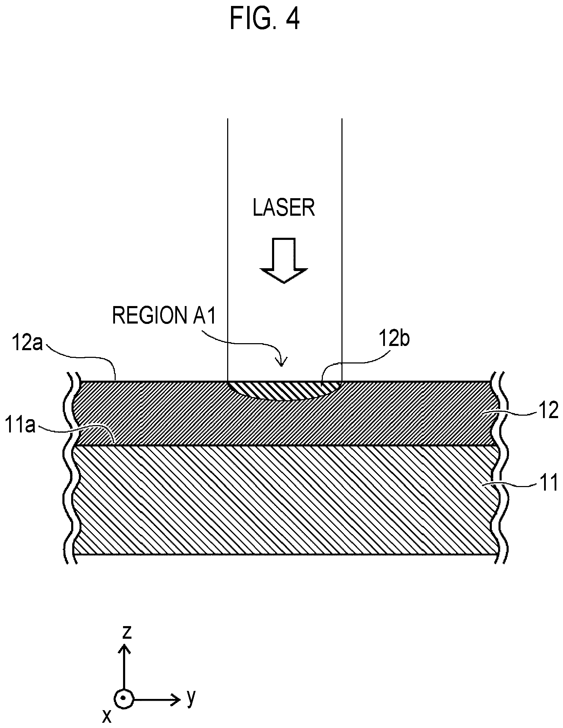

As a result, a part of the thin metal film 12 in the predetermined region A1 is melted (see step S102 of FIG 2 and FIG 4). Hereinafter, the thin metal film 12 that has been melted is referred to as a molten metal 12b.

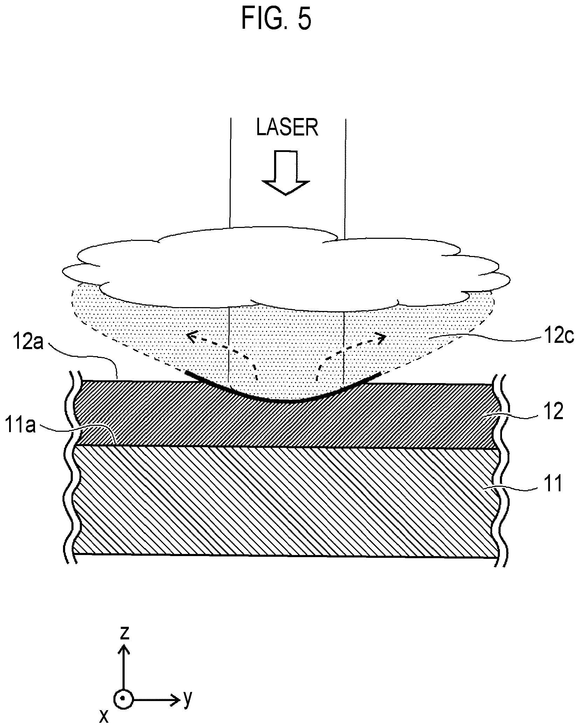

Then, the molten metal 12b is vaporized and released to a gas atmosphere (see step S103 of FIG2 and 5). Hereinafter, the molten metal 12b that has been vaporized is referred to as a metal vapor 12c.

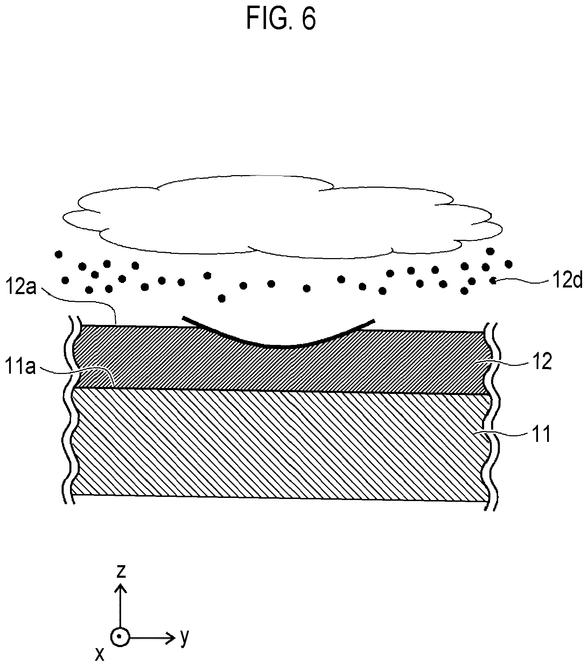

The metal vapor 12c stays in the gas atmosphere and then condenses into particles as it is or reacts with gas to become particles (see step S104 of FIG 2 and 6) as time passes. Hereinafter, the metal vapor 12c that has become particles is referred to as a metal particles 12d.

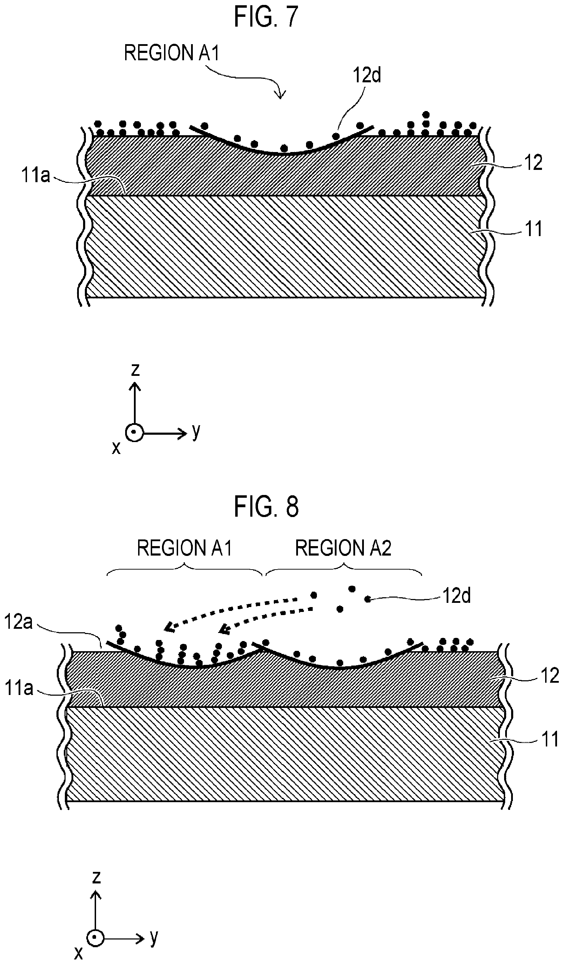

Then, the metal particles 12d are deposited on the surface 12a (including the predetermined region A1) of the thin metal film 12 (see step S105 of FIG2 and FIG 7).

When the metal particles 12d deposited on the predetermined region A1 have been solidified, the same treatments as the treatments (the treatments of step S101 to step S105) carried out on the predetermined region A1 are also carried out subsequently on a predetermined region A2 of the surface 12a of the thin metal film 12, where the predetermined region A2 is adjacent to the predetermined region A1. As a result, the metal in the predetermined region A2 is melt and vaporized in a deposit in the predetermined region A1, and then becomes deposited as particles. In other words, the deposit in the predetermined region A1 grows by the deposition of the particles from the predetermined region A2 (see step S106 of FIG 2 and FIG 8).

It is noted that metal particles are not deposited in the deposit in a portion of the predetermined region A1, where the portion is shaded from the scattering direction of the metal particles that fly from the adjacent region (the projection effect). As a result, the deposit in the predetermined region A1 does not become too fine and grows to have an uneven shape, for example, of a nanometer order.

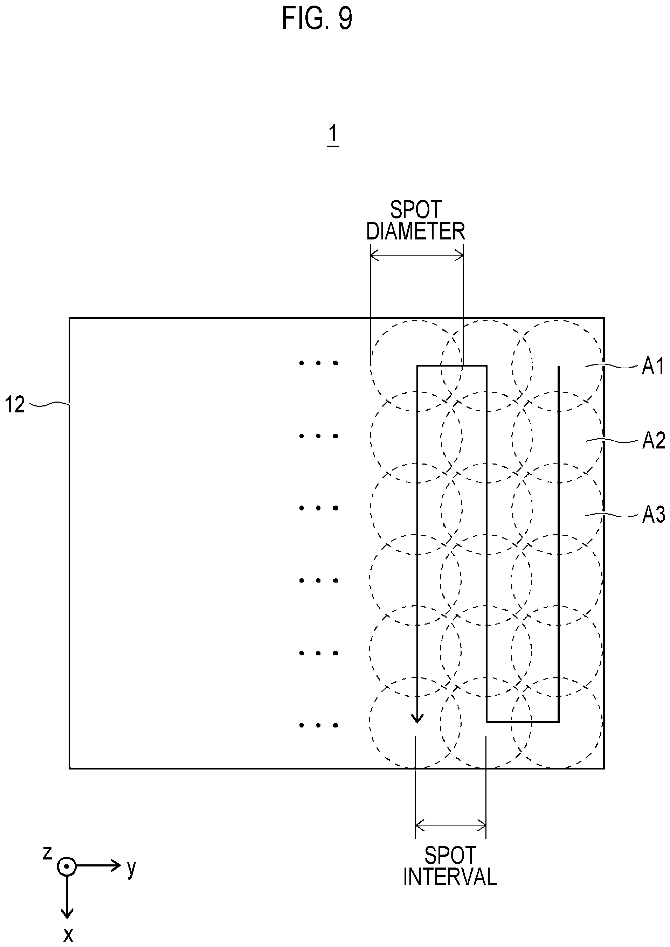

When the metal particles 12d deposited on the predetermined region A2 have been solidified, the same treatments as the treatments carried out on the predetermined region A1 or the predetermined region A2 are also carried out subsequently on a predetermined region A3 of the surface 12a of the thin metal film 12, where the predetermined region A3 is adjacent to the predetermined region A2. As a result, the metal in the predetermined region A3 is melt and vaporized in a deposit in the predetermined region A2, and then becomes deposited as particles. In other words, the deposit in the predetermined region A3 grows by the deposition of the particles from the predetermined region A2. The treatments are repeated in all or a part of the surface 12a of the thin metal film 12 (see FIG 9).

Through such processes as described above, the metal member 1 having the uneven portion 13 is manufactured.

A case where the molten metal 12b is vaporized to become the metal vapor 12c has been described in the treatment of step S103 as an example, but the present invention is not limited to this. In the treatment of step S103, the molten metal 12b may be caused to be plasma to become metal plasma. In this case, the metal plasma is released to a plasma atmosphere.

As described above, in the method of manufacturing the metal member 1, a metal in the predetermined region A1 of the surface 12a of the thin metal film 12 is melted and vaporized by the irradiation with the pulse laser, and then becomes particles and the particles are deposited in the predetermined region A1, and a metal in the predetermined region A2 of the surface 12a of the thin metal film 12, where the predetermined region A2 is adjacent to the predetermined region A1, is melted and vaporized by the irradiation with the pulse laser, and then becomes particles and the particles are deposited in each of the predetermined region A1 and the predetermined region A2. At this time, the deposit in the predetermined region A1 grows by the deposition of the particles from the predetermined region A2. In the same manner, the deposit in the predetermined region A2 grows by the deposition of the particles from the predetermined region A3 that is adjacent to the predetermined region A2. As a result, in the manufacturing method for the metal member 1, since the uneven portion 13 having a fine uneven shape can be formed even on the surface 12a of the thin metal film 12 containing a material having a low melting point, such as Al or Cu, as a main component, the adhesiveness between the thin metal film 12 (in other words, the metal member 1) and another member can be improved.

Further, for example, in a case where the thin metal film 12 and another member are adhered to each other by using an adhesive agent, the anchoring effect can be enhanced by the fine uneven shape. Alternatively, as another application, in a case where the thin metal film 12 and another member are caused to move slidingly using a lubricant, it is possible to restrain the lubricant from being diffused.

### Example of Manufacturing Result of Metal Member 1 (Cu as Main Component)

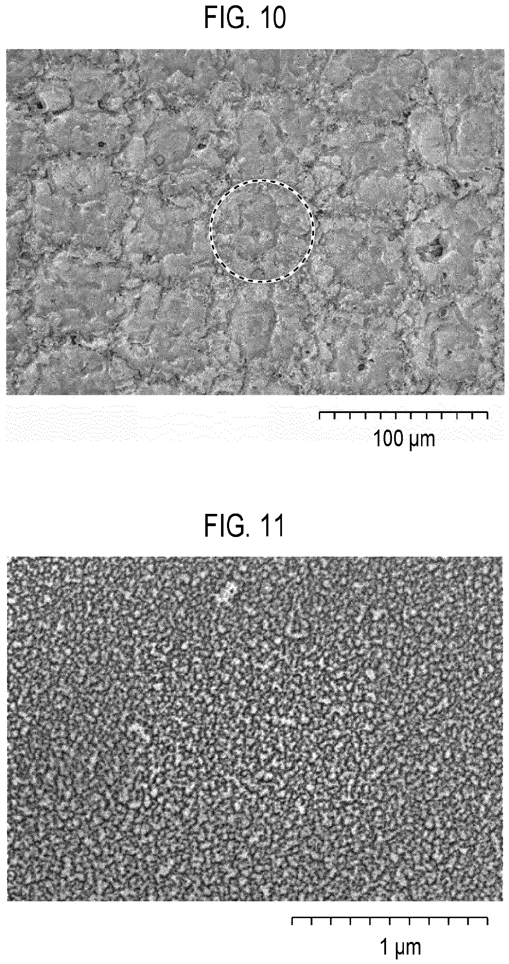

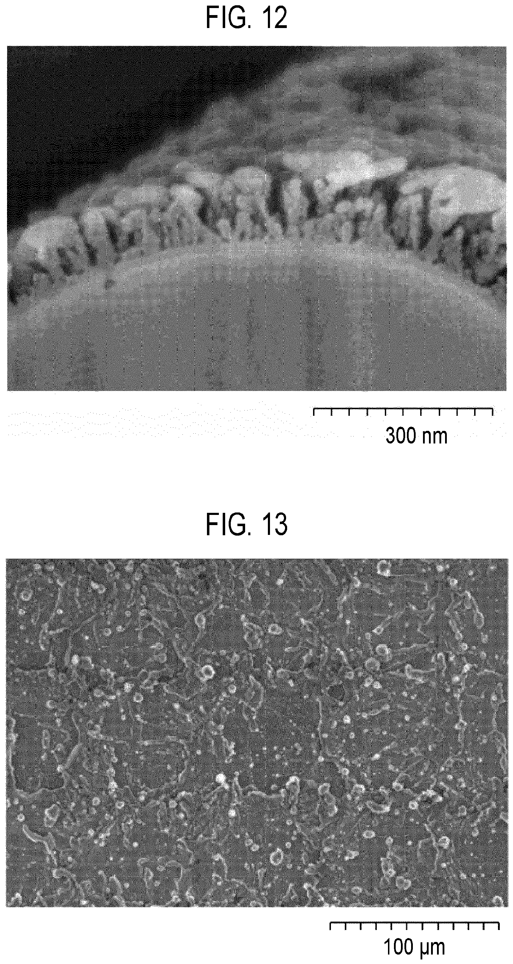

Subsequently, observation results of the actually manufactured metal member 1 will be described with reference to FIG 10 to FIG 12. FIG 10 is an enlarged SEM (Scanning Electron Microscope) image of the surface 12a of the thin metal film 12 provided in the metal member 1. FIG 11 is a further enlarged SEM image of the surface 12a of the thin metal film 12 provided in the metal member 1. FIG 12 is an enlarged SEM image of a cross section of the thin metal film 12 provided in the metal member 1.

Here, in the examples of FIG 10 to FIG 12, the thin metal film 12 provided in the metal member 1 is made of a metal material (a C1100 material) containing Cu as a main component.

Further, in these examples, irradiation conditions of the pulse laser are; a laser wavelength of 1,064 nm, a peak output of 20 kW, a pulse width of 50 ns, a laser spot diameter (a diameter of each of the predetermined region A1, the predetermined region A2, or the like) of 75 µm, and a spot interval (for example, an interval between the predetermined region A1 and the predetermined region A2 adjacent to each other) of 59 µm.

First, with reference to FIG 10, as indicated by the dotted line in the figure, it can be seen that a processed groove is formed on the surface 12a of the thin metal film 12 by irradiation with the pulse laser.

Further, with reference to FIG 11, it can be seen that the uneven portion 13 having an uneven shape of a nanometer order is formed on the surface 12a of the thin metal film 12. Further, with reference to FIG 12, it can be seen that deposit that constitutes the uneven portion 13 has grown and extended long.

The irradiation conditions of the pulse laser are not limited to the above case and may be at least; a peak output of 6 kW or more, a pulse width of 1 ns to 1,000 ns, a laser spot diameter of 200 µm or less, and a spot interval of equal to or smaller than the laser spot diameter.

### Another Example of Manufacturing Result of Metal Member 1 (Al as Main Component)

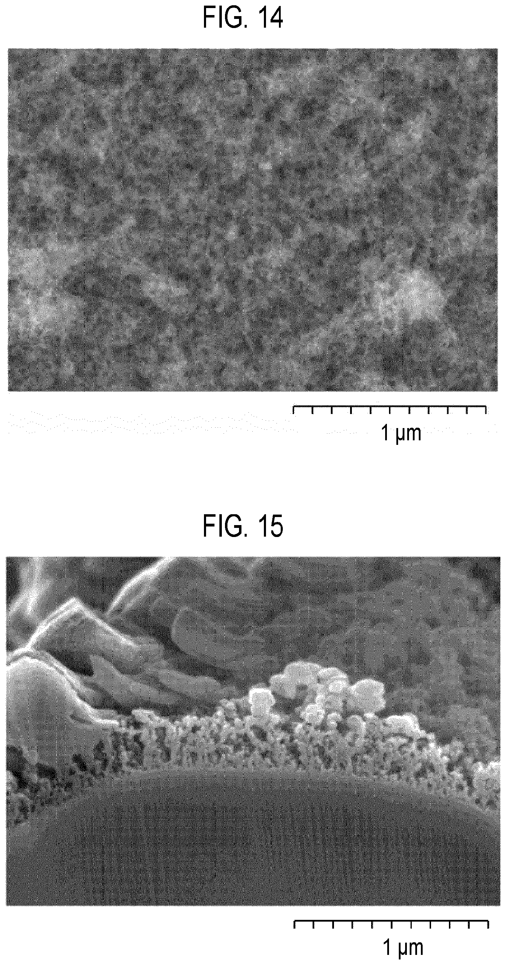

Next, another example of the observation results of the actually manufactured metal member 1 will be described with reference to FIG 13 to 15. FIG 13 is an enlarged SEM image of the surface 12a of the thin metal film 12 provided in the metal member 1. FIG 14 is an enlarged SEM image of the surface 12a of the thin metal film 12 provided in the metal member 1. FIG 15 is an enlarged SEM image of a cross section of the thin metal film 12 provided in the metal member 1.

Here, in the examples of FIG 13 to FIG 15, the thin metal film 12 provided in the metal member 1 is made of a metal material (an A1050 material) containing Al as a main component.

Further, in these examples, irradiation conditions of the pulse laser are; a laser wavelength of 1,064 nm, a peak output of 5.3 kW, a pulse width of 150 ns, a laser spot diameter of 80 µm, and a spot interval of 75 µm.

With reference to FIG 13 and FIG 14, it can be inferred that the surface 12a of the thin metal film 12 has a mottled pattern and the uneven portion 13 having an uneven shape is formed on the surface 12a of the thin metal film 12. Further, with reference to FIG 15, it can be seen that the uneven portion 13 having an uneven shape of a nanometer order is formed, and the deposit constituting the uneven shape has grown and extended long.

The irradiation conditions of the pulse laser are not limited to the above case and may be at least; a peak output of 3 kW or more, a pulse width of 1 ns to 1,000 ns, a laser spot diameter of 200 µm or less, and a spot interval of equal to or smaller than the laser spot diameter.

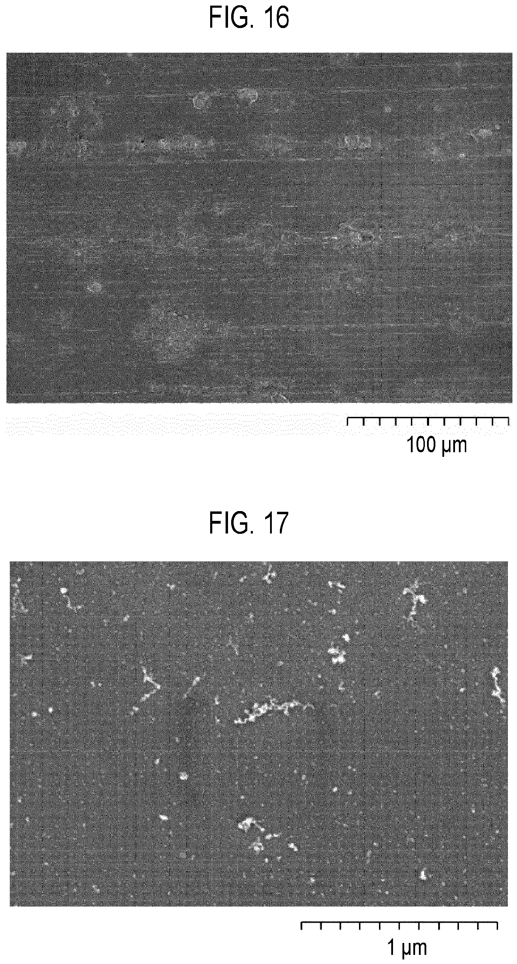

Even in the case where irradiation conditions of the pulse laser with which the surface 12a of the thin metal film 12 containing Cu as a main component is irradiated are the same as the irradiation conditions of the pulse laser with which the surface 12a of the thin metal film 12 containing Al as a main component is irradiated, the desired uneven shape may not be always formed (see SEM images of FIG 16 to FIG 18). That is, optimum irradiation conditions of the pulse laser are different depending on the main component of the thin metal film 12.

### Another Example of Manufacturing Result of Metal Member 1 (Sn as Main Component)

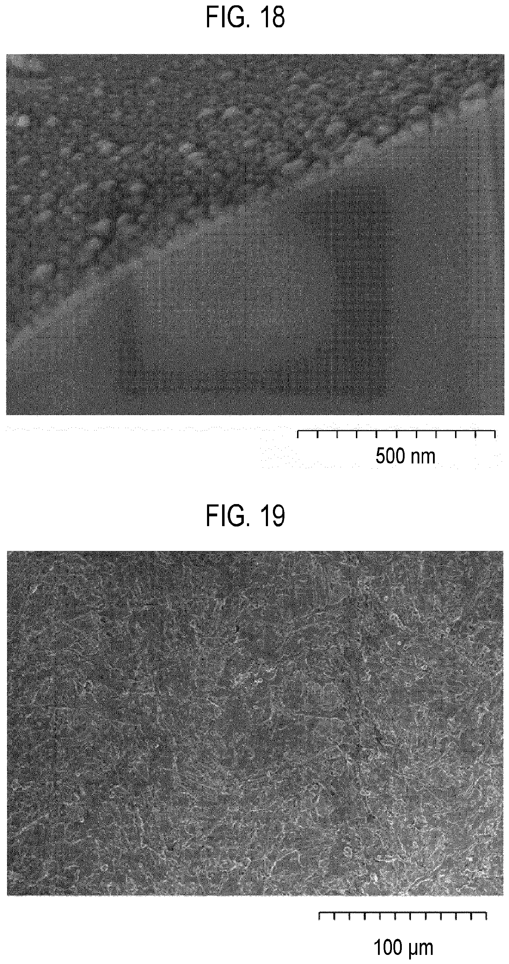

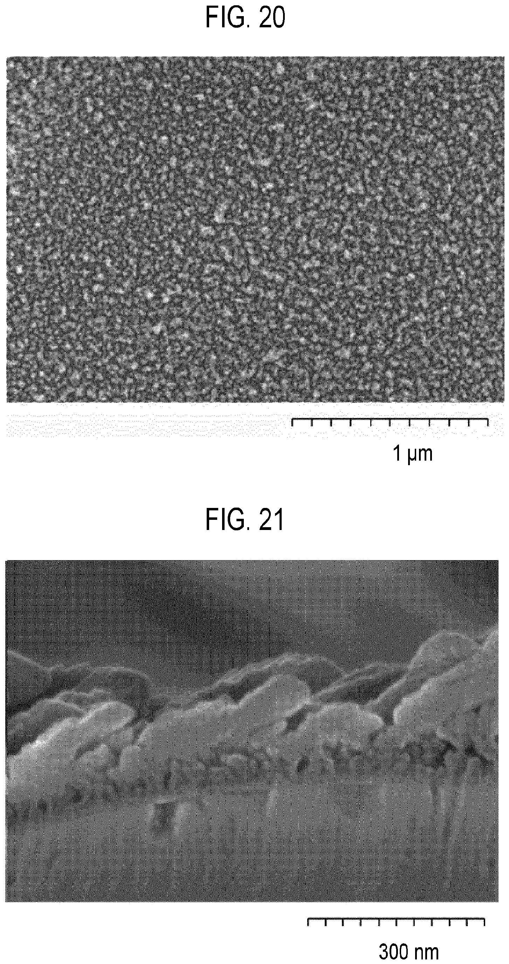

Next, another example of the observation results of the actually manufactured metal member 1 will be described with reference to FIG 19 to 21. FIG 19 is an enlarged SEM image of the surface 12a of the thin metal film 12 provided in the metal member 1. FIG 20 is an enlarged SEM image of the surface 12a of the thin metal film 12 provided in the metal member 1. FIG 21 is an enlarged SEM image of a cross section of the thin metal film 12 provided in the metal member 1.

Here, in the examples of FIG 19 to FIG 21, the thin metal film 12 provided in the metal member 1 is made of a metal material (Sn-plated) containing Sn as a main component.

Further, in these examples, irradiation conditions of the pulse laser are; a laser wavelength of 1,064 nm, a peak output of 5.3 kW, a pulse width of 150 ns, a laser spot diameter of 80 µm, and a spot interval of 75 µm.

With reference to FIG 19 and FIG 20, it can be inferred that the surface 12a of the thin metal film 12 has a mottled pattern and the uneven portion 13 having an uneven shape is formed on the surface 12a of the thin metal film 12. Further, with reference to FIG 21, it can be seen that the uneven portion 13 having an uneven shape of a nanometer order is formed, and the deposit constituting the uneven shape has grown and extended long.

The irradiation conditions of the pulse laser are not limited to the above case and may be at least; a peak output of 1 kW or more, a pulse width of 1 ns to 1,000 ns, a laser spot diameter of 250 µm or less, and a spot interval of equal to or smaller than the laser spot diameter.

### Another Example of Manufacturing Result of Metal Member 1 (Ti as Main Component)

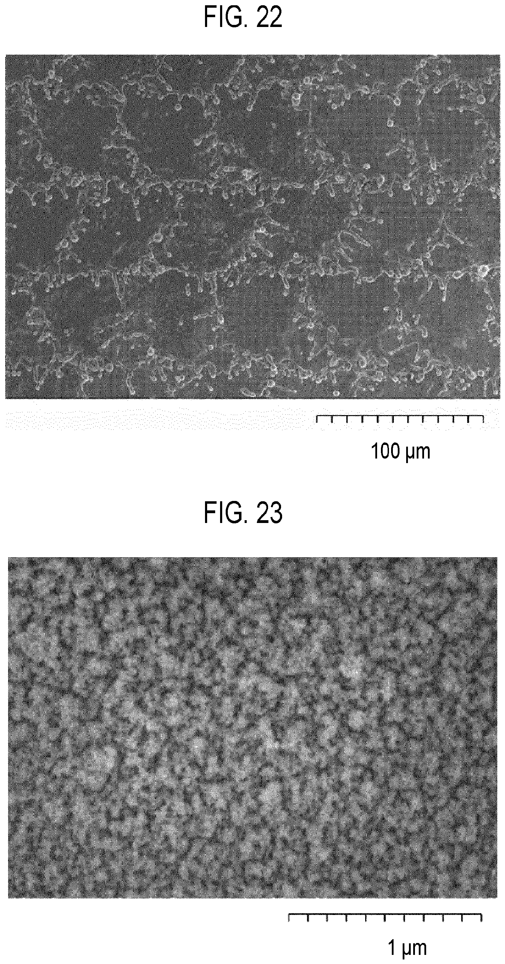

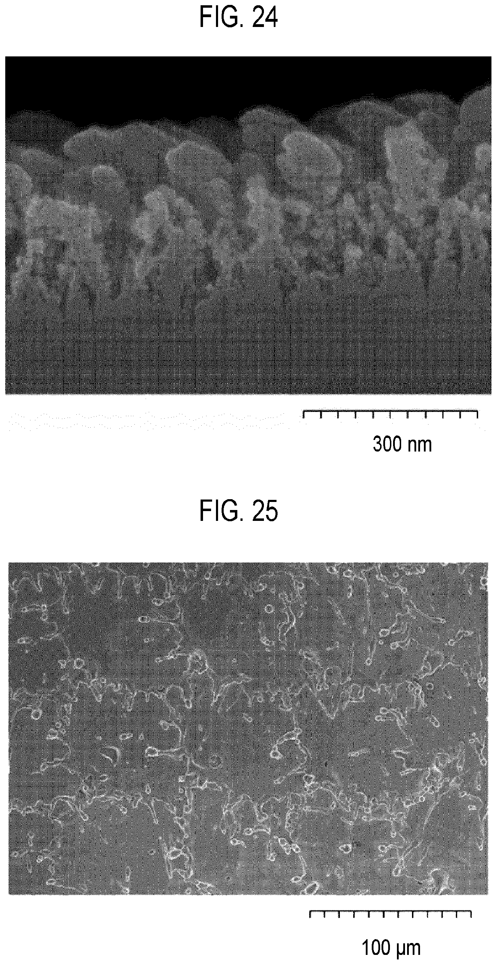

Next, another example of the observation results of the actually manufactured metal member 1 will be described with reference to FIG 22 to 24. FIG 22 is an enlarged SEM image of the surface 12a of the thin metal film 12 provided in the metal member 1. FIG 23 is an enlarged SEM image of the surface 12a of the thin metal film 12 provided in the metal member 1. FIG 24 is an enlarged SEM image of a cross section of the thin metal film 12 provided in the metal member 1.

Here, in the examples of FIG 22 to FIG 24, the thin metal film 12 provided in the metal member 1 is made of a metal material containing Ti as a main component.

Further, in these examples, irradiation conditions of the pulse laser are; a laser wavelength of 1,064 nm, a peak output of 20 kW, a pulse width of 50 ns, a laser spot diameter of 75 µm, and a spot interval of 59 µm.

With reference to FIG 22 and FIG 23, it can be inferred that the surface 12a of the thin metal film 12 has a mottled pattern and the uneven portion 13 having an uneven shape is formed on the surface 12a of the thin metal film 12. Further, with reference to FIG 24, it can be seen that the uneven portion 13 having an uneven shape of a nanometer order is formed, and the deposit constituting the uneven shape has grown and extended long.

The irradiation conditions of the pulse laser are not limited to the above case and may be at least; a peak output of 1 kW or more, a pulse width of 1 ns to 1,000 ns, a laser spot diameter of 250 µm or less, and a spot interval of equal to or smaller than the laser spot diameter.

### Another Example of Manufacturing Result of Metal Member 1 (Fe as Main Component)

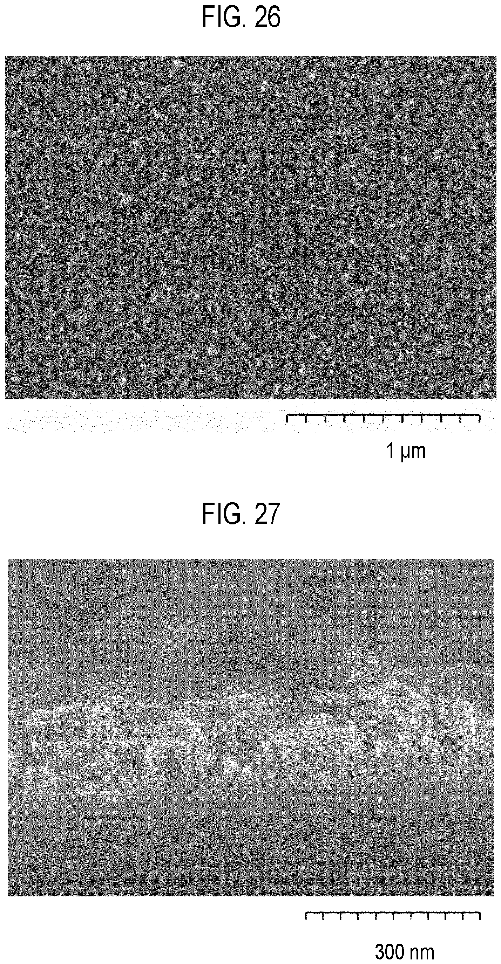

Next, another example of the observation results of the actually manufactured metal member 1 will be described with reference to FIG 25 to 27. FIG 25 is an enlarged SEM image of the surface 12a of the thin metal film 12 provided in the metal member 1. FIG 26 is a further enlarged SEM image of the surface 12a of the thin metal film 12 provided in the metal member 1. FIG 27 is an enlarged SEM image of a cross section of the thin metal film 12 provided in the metal member 1.

Here, in the examples of FIG 25 to FIG 27, the thin metal film 12 provided in the metal member 1 is made of a metal material (SUS304) containing Fe as a main component.

Further, in these examples, irradiation conditions of the pulse laser are; a laser wavelength of 1,064 nm, a peak output of 5.3 kW, a pulse width of 150 ns, a laser spot diameter of 80 µm, and a spot interval of 75 µm.

With reference to FIG 25 and FIG 26, it can be inferred that the surface 12a of the thin metal film 12 has a mottled pattern and the uneven portion 13 having an uneven shape is formed on the surface 12a of the thin metal film 12. Further, with reference to FIG 27, it can be seen that the uneven portion 13 having an uneven shape of a nanometer order is formed, and the deposit constituting the uneven shape has grown and extended long.

The irradiation conditions of the pulse laser are not limited to the above case and may be at least; a peak output of 1 kW or more, a pulse width of 1 ns to 1,000 ns, a laser spot diameter of 250 µm or less, and a spot interval of equal to or smaller than the laser spot diameter.

As described above, in the method of manufacturing the metal member 1, a metal in the predetermined region A1 of the surface 12a of the thin metal film 12 is melted and vaporized by the irradiation with the pulse laser, and then becomes particles and the particles are deposited in the predetermined region A1, and a metal in the predetermined region A2 of the surface 12a of the thin metal film 12, where the predetermined region A2 is adjacent to the predetermined region A1, is melted and vaporized by the irradiation with the pulse laser, and then becomes particles and the particles are deposited in each of the predetermined region A1 and the predetermined region A2. At this time, the deposit in the predetermined region A1 grows by the deposition of the particles from the predetermined region A2. In the same manner, the deposit in the predetermined region A2 grows by the deposition of the particles from the predetermined region A3 that is adjacent to the predetermined region A2. As a result, in the manufacturing method for the metal member 1, since the uneven portion 13 having a fine uneven shape can be formed even on the surface 12a of the thin metal film 12 containing a material having a low melting point, such as Cu, Al, Sn, Ti, or Fe, as a main component, the adhesiveness between the thin metal film 12 (in other words, the metal member 1) and another member can be improved.

Further, for example, in a case where the thin metal film 12 and another member are adhered to each other by using an adhesive agent, the anchoring effect can be enhanced by the fine uneven shape. Alternatively, as another application, in a case where the thin metal film 12 and another member are caused to move slidingly using a lubricant, it is possible to restrain the lubricant from being diffused.

The present invention is not limited to the above embodiment and can be appropriately modified without departing from the scope of the present invention as defined in the appended claims.

In the above embodiment, a case where the thin metal film 12 is formed on the surface of the base material 11 and the uneven portion 13 having an uneven shape is formed on the surface 12a of the thin metal film 12 has been described as an example, but the present invention is limited to this. For example, the entire base material 11 or at least a surface of the base material 11 may be made of a metal material containing any one of Cu, Al, Sn, Ti, and Fe which have a low melting point, as a main component, and the uneven portion 13 having uneven shape may be formed on the surface of the base material 11.

### Second Embodiment

Hereinafter, a metal member 2 will be described. The metal member 2 is a member in which the uneven shape of the uneven portion 13 formed on the surface (more specifically, the surface 12a of the thin metal film 12) of the metal member 1 is partially densified.

Due to the uneven shape of the uneven portion 13 formed on the surface of the metal member 2, the adhesiveness between the metal member 2 and another member can be improved as in the case of the metal member 1. In addition, in the metal member 2, the uneven shape of the uneven portion 13 formed on the surface of the metal member is partially densified as compared with another part, and thus insulation resistance performance, corrosion resistance performance, and wear resistance performance can be improved in the densified part.

### Manufacturing Method for Metal Member 2

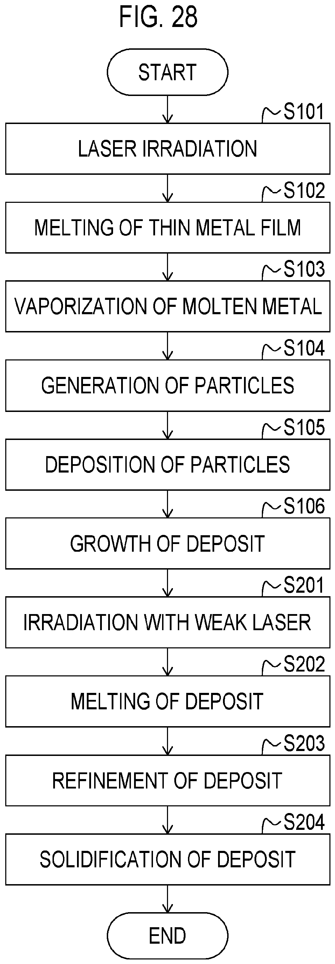

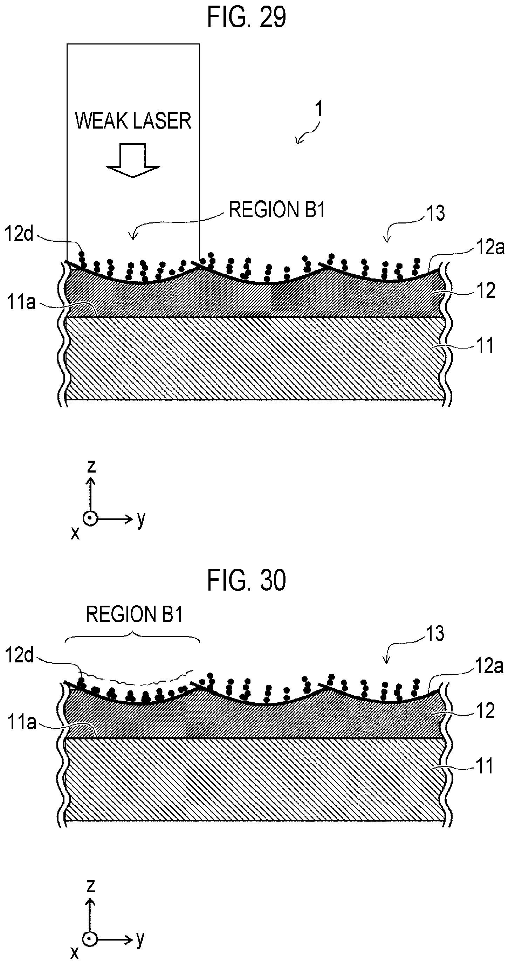

Subsequently, a method of manufacturing the metal member 2 will be described. FIG 28 is a flowchart illustrating a method of manufacturing the metal member 2. In addition, FIG29 to FIG 32 are schematic cross-sectional views for describing the manufacturing method for the metal member 2. FIG 29 to FIG 32 correspond to treatments of step S201 to step S204 of FIG 28, respectively.

First, the metal member 1 having the uneven portion 13 is manufactured through the treatments of step S 101 to step S 106 already described.

Then, a predetermined region B 1 of the uneven portion 13 formed on the surface of the metal member 1 is irradiated with a pulse laser weaker than the pulse laser (used in the treatment of step S101) used at the time of forming the uneven portion 13 (see step S201 of FIG 28 and FIG 29). The predetermined region B1 is, for example, a region that can be irradiated with a weak pulse laser at one time.

Here, the irradiation of the weak pulse laser does not have to be performed in a low oxygen atmosphere and may be performed, for example, in an air atmosphere or the like. As a result, for example, after forming the uneven portion 13 on the surface of the metal member 1, the uneven shape of the uneven portion 13 can be partially densified without adjusting the atmosphere.

By the irradiation with the weak pulse laser, the deposit (the metal particles 12d) that forms the uneven shape of the uneven portion 13 in the predetermined region B1 is melted (see step S202 of FIG 28 and FIG 30).

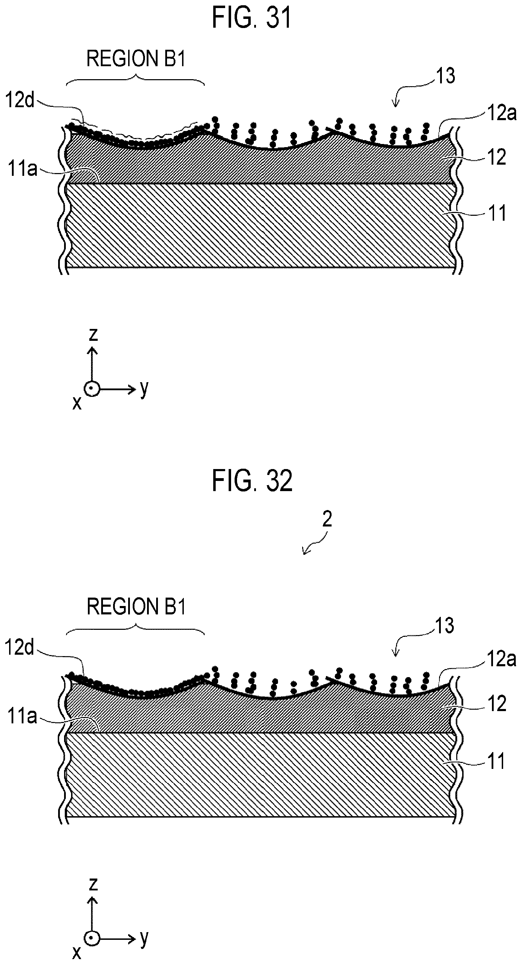

As the deposit in the predetermined region B 1 becomes melted, the deposit becomes densified (see step S203 of FIG 28 and FIG 31).

Then, the densified deposit in the predetermined region B 1 is solidified (see step S204 of FIG 28 and FIG 32).

Through such processes as described above, the metal member 2 having the uneven portion 13 that is partially densified is manufactured.

### Example of Manufacturing Result of Metal Member 2 (Cu as Main Component)

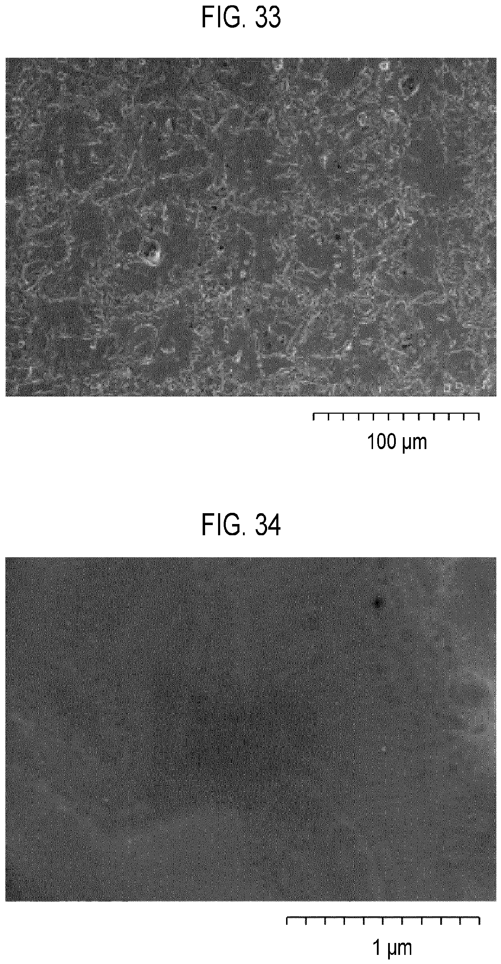

Subsequently, observation results of the densified portion of the actually manufactured metal member 2 will be described with reference to FIG 33 to FIG 35.

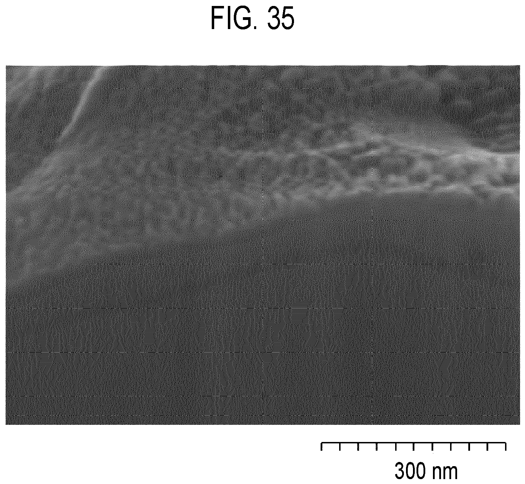

FIG 33 is an enlarged SEM image of a part in which an uneven shape is densified by a weak laser, in the surface 12a of a thin metal film 12 which is provided in the metal member 2. FIG 34 is a further enlarged SEM image of the surface 12a of the thin metal film 12 shown in FIG 33. FIG 35 is an enlarged SEM image of a cross section of the thin metal film 12 shown in FIG 33.

Here, in the examples of FIG 33 to FIG 35, the thin metal film 12 provided in the metal member 2 is made of a metal material (a C1100 material) containing Cu as a main component. As a result, in the undensified portion, SEM images similar to the images of FIG 10 to FIG 12 are observed.

Further, in these examples, irradiation conditions of the weak pulse laser are; a pulse width of 1 ns to 1,000 ns, a pulse energy of 0.001 mJ/pulse to 0.1 mJ/pulse, and an energy density of 0.01 mJ/mm² to 10 mJ/mm².

With reference to FIG 33 to 35, the uneven shape of the uneven portion 13 formed on the surface 12a of the thin metal film 12 is densified (in other words, smoothened) as can be seen in comparison with FIG 10 to FIG 12.

In this manner, in the method of manufacturing the metal member 2 according to the present embodiment, after the uneven portion 13 is formed on the surface of the metal member 2, the uneven shape of the uneven portion 13 can be partially densified without adjusting the atmosphere. Further, in the method of manufacturing the metal member 2 according to the present embodiment, due to the uneven shape of the uneven portion 13 formed on the surface of the metal member 2, the adhesiveness between the metal member 2 and another member can be improved as in the case of the metal member 1. Further, in the method of manufacturing the metal member 2 according to the embodiment of the present invention, the uneven shape of the uneven portion 13 formed on the surface of the metal member is partially densified as compared with another part, and thus insulation resistance performance, corrosion resistance performance, and wear resistance performance can be improved in the densified part.

## Claims

1. A method of manufacturing a metal member that includes a base material (11) of which at least a surface is made of a material, and an uneven portion (13) having an uneven shape, which is formed on the surface of the base material (11), the manufacturing method comprising forming the uneven portion (13),
wherein forming the uneven portion (13) includes;
irradiating a first region of the surface of the base material (11) with a pulse-oscillating laser beam to melt the surface of the base material (11) in the first region,
generating metal particles from a vapor or plasma of a metal released to a predetermined atmosphere by the melting of the surface of the base material (11) in the first region by the irradiating the first region, and depositing the metal particles in the first region, wherein the metal particles contain material from the surface and make an uneven portion (13),
irradiating a second region of the surface of the base material (11) with the pulse-oscillating laser beam, the second region being adjacent to the first region, to melt the surface of the base material (11) in the second region, and
generating metal particles from a vapor or plasma of a metal released to the predetermined atmosphere by the melting of the surface of the base material (11) in the second region by the irradiating the second region, and depositing the metal particles in each of the second region and the first region adjacent to the second region, wherein the metal particles contain material from the surface and make an uneven portion (13),
**characterized in that** the material of the surface contains any one of Cu, Al, Sn, Ti, and Fe as a main component; and
**in that** either:
(i) the base material (11) is made of a material containing Al as a main component; and
irradiation conditions of the laser beam include a peak output of 3 kW or more, a pulse width of 1 ns to 1,000 ns, a laser spot diameter of 200 µm or less, the laser spot diameter being a diameter of each of the first region and the second region, and a spot interval of equal to or smaller than the laser spot diameter, the spot interval being an interval between the first region and the second region; or
(ii) the base material (11) is made of a material containing Cu as a main component; and
irradiation conditions of the laser beam include a peak output of 6 kW or more, a pulse width of 1 ns to 1,000 ns, a laser spot diameter of 200 µm or less, the laser spot diameter being a diameter of each of the first region and the second region, and a spot interval of equal to or smaller than the laser spot diameter, the spot interval being an interval between the first region and the second region; or
(iii) the base material (11) is made of a material containing Sn as a main component; and
irradiation conditions of the laser beam include a peak output of 1 kW or more, a pulse width of 1 ns to 1,000 ns, a laser spot diameter of 250 µm or less, the laser spot diameter being a diameter of each of the first region and the second region, and a spot interval of equal to or smaller than the laser spot diameter, the spot interval being an interval between the first region and the second region; or
(iv) the base material (11) is made of a material containing Ti as a main component; and
irradiation conditions of the laser beam include a peak output of 1 kW or more, a pulse width of 1 ns to 1,000 ns, a laser spot diameter of 250 µm or less, the laser spot diameter being a diameter of each of the first region and the second region, and a spot interval of equal to or smaller than the laser spot diameter, the spot interval being an interval between the first region and the second region; or
(v) the base material (11) is made of a material containing Fe as a main component; and
irradiation conditions of the laser beam include a peak output of 1 kW or more, a pulse width of 1 ns to 1,000 ns, a laser spot diameter of 250 µm or less, the laser spot diameter being a diameter of each of the first region and the second region, and a spot interval of equal to or smaller than the laser spot diameter, the spot interval being an interval between the first region and the second region.

2. The method according to claim 1, wherein
the surface of the base material (11) has a thin metal film (12), that is made of the material containing any one of Cu, Al, Sn, Ti, and Fe as a main component; and the uneven portion (13) is formed on a surface (12a) of the thin metal film (12).

3. The method according to any one of claims 1 or 2, further comprising
partially densifying the uneven shape of the uneven portion (13), after forming the uneven portion (13),
wherein the partial densifying of the uneven shape of the uneven portion (13) includes
irradiating a predetermined region of the uneven portion (13) formed on the surface of the base material (11) with a laser beam weaker than the laser beam that is used in forming the uneven portion (13), to melt a deposit that forms the uneven shape of the uneven portion (13) in the predetermined region.

## Patentansprüche

1. Verfahren zur Herstellung eines Metallteils, das Folgendes enthält: ein Basismaterial (11), von dem mindestens eine Oberfläche aus einem Material hergestellt ist, und einen unebenen Abschnitt (13) mit einer unebenen Form, der auf der Oberfläche des Basismaterials (11) gebildet wird, wobei das Herstellungsverfahren das Bilden des unebenen Abschnitts (13) umfasst,
wobei das Bilden des unebenen Abschnitts (13) Folgendes enthält;
Bestrahlen eines ersten Bereichs der Oberfläche des Basismaterials (11) mit einem pulsierenden Laserstrahl, um die Oberfläche des Basismaterials (11) in dem ersten Bereich zu schmelzen,
Erzeugen von Metallpartikeln aus einem Dampf oder Plasma eines Metalls, das durch das Schmelzen der Oberfläche des Basismaterials (11) in dem ersten Bereich durch Bestrahlen des ersten Bereichs an eine vorbestimmte Atmosphäre abgegeben wird, und Ablagern der Metallpartikel in dem ersten Bereich, wobei die Metallpartikel Material von der Oberfläche enthalten und einen unebenen Abschnitt (13) bilden,
Bestrahlen eines zweiten Bereichs der Oberfläche des Basismaterials (11) mit dem pulsierenden Laserstrahl, wobei der zweite Bereich an den ersten Bereich angrenzt, um die Oberfläche des Basismaterials (11) in dem zweiten Bereich zu schmelzen, und
Erzeugen von Metallpartikeln aus einem Dampf oder Plasma eines Metalls, das durch das Schmelzen der Oberfläche des Basismaterials (11) in dem zweiten Bereich durch Bestrahlen des zweiten Bereichs an die vorbestimmte Atmosphäre abgegeben wird, und Ablagern der Metallteilchen sowohl in dem zweiten Bereich als auch in dem an den zweiten Bereich angrenzenden ersten Bereich, wobei die Metallteilchen Material von der Oberfläche enthalten und einen unebenen Abschnitt (13) bilden,
**dadurch gekennzeichnet, dass** das Material der Oberfläche eines von Cu, Al, Sn, Ti und Fe als eine Hauptkomponente enthält; und
dadurch, dass entweder:
(i) das Basismaterial (11) aus einem Material hergestellt ist, das Al als Hauptkomponente enthält; und
die Bestrahlungsbedingungen des Laserstrahls Folgendes enthalten: eine Spitzenleistung von 3 kW oder mehr, eine Pulsbreite von 1 ns bis 1.000 ns und einen Laserfleckdurchmesser von 200 µm oder weniger, wobei der Laserpunktdurchmesser Folgendes ist: ein Durchmesser sowohl des ersten Bereichs als auch des zweiten Bereichs, und ein Punktintervall, das gleich oder kleiner als der Laserpunktdurchmesser ist, wobei der Punktabstand ein Abstand zwischen dem ersten Bereich und dem zweiten Bereich ist; oder
(ii) das Basismaterial (11) aus einem Material hergestellt ist, das Cu als Hauptkomponente enthält; und
die Bestrahlungsbedingungen des Laserstrahls Folgendes enthalten: eine Spitzenleistung von 6 kW oder mehr, eine Pulsbreite von 1 ns bis 1.000 ns und einen Laserfleckdurchmesser von 200 µm oder weniger, wobei der Laserpunktdurchmesser Folgendes ist: ein Durchmesser sowohl des ersten Bereichs als auch des zweiten Bereichs, und ein Punktintervall, das gleich oder kleiner als der Laserpunktdurchmesser ist, wobei der Punktabstand ein Abstand zwischen dem ersten Bereich und dem zweiten Bereich ist; oder
(iii) das Basismaterial (11) aus einem Material hergestellt ist, das Sn als Hauptkomponente enthält; und
die Bestrahlungsbedingungen des Laserstrahls Folgendes enthalten: eine Spitzenleistung von 1 kW oder mehr, eine Pulsbreite von 1 ns bis 1.000 ns und einen Laserfleckdurchmesser von 250 µm oder weniger, wobei der Laserpunktdurchmesser Folgendes ist: ein Durchmesser sowohl des ersten Bereichs als auch des zweiten Bereichs, und ein Punktintervall, das gleich oder kleiner als der Laserpunktdurchmesser ist, wobei der Punktabstand ein Abstand zwischen dem ersten Bereich und dem zweiten Bereich ist; oder
(iv) das Basismaterial (11) aus einem Material hergestellt ist, das Ti als Hauptkomponente enthält; und
die Bestrahlungsbedingungen des Laserstrahls Folgendes enthalten: eine Spitzenleistung von 1 kW oder mehr, eine Pulsbreite von 1 ns bis 1.000 ns und einen Laserfleckdurchmesser von 250 µm oder weniger, wobei der Laserpunktdurchmesser Folgendes ist: ein Durchmesser sowohl des ersten Bereichs als auch des zweiten Bereichs, und ein Punktintervall, das gleich oder kleiner als der Laserpunktdurchmesser ist, wobei der Punktabstand ein Abstand zwischen dem ersten Bereich und dem zweiten Bereich ist; oder
(v) das Basismaterial (11) aus einem Material hergestellt ist, das Fe als Hauptkomponente enthält; und
die Bestrahlungsbedingungen des Laserstrahls Folgendes enthalten: eine Spitzenleistung von 1 kW oder mehr, eine Pulsbreite von 1 ns bis 1.000 ns und einen Laserfleckdurchmesser von 250 µm oder weniger, wobei der Laserpunktdurchmesser Folgendes ist: ein Durchmesser sowohl des ersten Bereichs als auch des zweiten Bereichs, und ein Punktintervall, das gleich oder kleiner als der Laserpunktdurchmesser ist, wobei der Punktabstand ein Abstand zwischen dem ersten Bereich und dem zweiten Bereich ist.

2. Verfahren nach Anspruch 1, wobei:
die Oberfläche des Basismaterials (11) einen dünnen Metallfilm (12) aufweist, der aus einem Material hergestellt ist, das Cu, Al, Sn, Ti oder Fe als Hauptkomponente enthält; und
der unebene Abschnitt (13) auf einer Oberfläche (12a) des dünnen Metallfilms (12) gebildet ist.

3. Verfahren nach einem der Ansprüche 1 oder 2, das ferner umfasst:
teilweises Verdichten der unebenen Form des unebenen Abschnitts (13) nach dem Bilden des unebenen Abschnitts (13),
wobei das teilweise Verdichten der unebenen Form des unebenen Abschnitts (13) Folgendes enthält:
Bestrahlen eines vorbestimmten Bereichs des unebenen Abschnitts (13), der auf der Oberfläche des Basismaterials (11) gebildet ist, mit einem Laserstrahl, der schwächer ist als der Laserstrahl, der bei der Bildung des unebenen Abschnitts (13) verwendet wird, um eine Ablagerung zu schmelzen, die die unebene Form des unebenen Abschnitts (13) in dem vorbestimmten Bereich bildet.

## Revendications

1. Procédé de fabrication d'un élément métallique qui comporte un matériau de base (11) dont au moins une surface est constituée d'un matériau, et une portion irrégulière (13) ayant une forme irrégulière, qui est formée sur la surface du matériau de base (11), le procédé de fabrication comprenant la formation de la portion irrégulière (13),
dans lequel la formation de la portion irrégulière (13) comporte ;
l'irradiation d'une première région de la surface du matériau de base (11) avec un faisceau laser pulsé oscillant pour faire fondre la surface du matériau de base (11) dans la première région,
la génération de particules métalliques à partir d'une vapeur ou d'un plasma d'un métal libéré vers une atmosphère prédéterminée par la fusion de la surface du matériau de base (11) dans la première région par l'irradiation de la première région, et le dépôt des particules métalliques dans la première région, dans lequel les particules métalliques contiennent du matériau issu de la surface et constituent une portion irrégulière (13),
l'irradiation d'une deuxième région de la surface du matériau de base (11) avec le faisceau laser pulsé oscillant, la deuxième région étant adjacente à la première région, pour faire fondre la surface du matériau de base (11) dans la deuxième région, et
la génération de particules métalliques à partir d'une vapeur ou d'un plasma d'un métal libéré vers l'atmosphère prédéterminée par la fusion de la surface du matériau de base (11) dans la deuxième région par l'irradiation de la deuxième région, et le dépôt des particules métalliques dans chacune de la deuxième région et de la première région adjacente à la deuxième région, dans lequel les particules métalliques contiennent du matériau issu de la surface et constituent une portion irrégulière (13),
**caractérisé en ce que** le matériau de la surface contient l'un quelconque parmi Cu, Al, Sn, Ti, et Fe, en tant que composant principal ;
**en ce que** soit :
(i) le matériau de base (11) est constitué d'un matériau contenant Al en tant que composant principal ; et
des conditions d'irradiations du faisceau laser comportent un pic de sortie de 3 kW ou plus, une largeur d'impulsion de 1 ns à 1000 ns, un diamètre de spot laser de 200 µm ou moins, le diamètre de spot laser étant un diamètre de chacune de la première région et de la deuxième région, et un intervalle de spot égal ou inférieur au diamètre de spot laser, l'intervalle de spot étant un intervalle entre la première région et la deuxième région ; soit
(ii) le matériau de base (11) est constitué d'un matériau contenant Cu en tant que composant principal ; et
des conditions d'irradiation du faisceau laser comportent un pic de sortie de 6 kW ou plus, une largeur d'impulsion de 1 ns à 1000 ns, un diamètre de spot laser de 200 µm ou moins, le diamètre de spot laser étant un diamètre de chacune de la première région et de la deuxième région, et un intervalle de spot égal ou inférieur au diamètre de spot laser, l'intervalle de spot étant un intervalle entre la première région et la deuxième région ; soit (iii) le matériau de base (11) est constitué d'un matériau contenant Sn en tant que composant principal ; et
des conditions d'irradiation du faisceau laser comportent un pic de sortie de 1 kW ou plus, une largeur d'impulsion de 1 ns à 1000 ns, un diamètre de spot laser de 250 µm ou moins, le diamètre de spot laser étant un diamètre de chacune de la première région et de la deuxième région, et un intervalle de spot égal ou inférieur au diamètre de spot laser, l'intervalle de spot étant un intervalle entre la première région et la deuxième région ; soit (iv) le matériau de base (11) est constitué d'un matériau contenant Ti en tant que composant principal ; et
des conditions d'irradiation du faisceau laser comportent un pic de sortie de 1 kW ou plus, une largeur d'impulsion de 1 ns à 1000 ns, un diamètre de spot laser de 250 µm ou moins, le diamètre de spot laser étant un diamètre de chacune de la première région et de la deuxième région, et un intervalle de spot égal ou inférieur au diamètre de spot laser, l'intervalle de spot étant un intervalle entre la première région et la deuxième région ; soit (v) le matériau de base (11) est constitué d'un matériau contenant Fe en tant que composant principal ; et
des conditions d'irradiation du faisceau laser comportent un pic de sortie de 1 kW ou plus, une largeur d'impulsion de 1 ns à 1000 ns, un diamètre de spot laser de 250 µm ou moins, le diamètre de spot laser étant un diamètre de chacune de la première région et de la deuxième région, et un intervalle de spot égal ou inférieur au diamètre de spot laser, l'intervalle de spot étant un intervalle entre la première région et la deuxième région.

2. Procédé selon la revendication 1, dans lequel :
la surface du matériau de base (11) a un film métallique mince (12), qui est constitué du matériau contenant l'un quelconque parmi Cu, Al, Sn, Ti, et Fe en tant que composant principal ; et
la portion irrégulière (13) est formée sur une surface (12a) du film métallique mince (12).

3. Procédé selon l'une quelconque des revendications 1 ou 2, comprenant en outre
la densification partielle de la forme irrégulière de la portion irrégulière (13), après la formation de la portion irrégulière (13),
dans lequel la densification partielle de la forme irrégulière de la portion irrégulière (13) comporte
l'irradiation d'une région prédéterminée de la portion irrégulière (13) formée sur la surface du matériau de base (11) avec un faisceau laser plus faible que le faisceau laser qui est utilisé dans la formation de la portion irrégulière (13), pour faire fondre un dépôt qui forme la forme irrégulière de la portion irrégulière (13) dans la région prédéterminée.
